# EUROPEAN PATENT APPLICATION

(11) **EP 4 362 611 A1**
(43) Date of publication of application: **01.05.2024**
(21) Application number: 22828256.2
(22) Date of filing: 13.06.2022
(51) Int. Cl.: H05K 1/09

(54) **WIRING BOARD**

(30) Priority: 24.06.2021 JP 2021105126
(71) Applicant: Kyocera Corporation, Kyoto-shi Kyoto 612-8501 (JP)
(72) Inventor: YUGAWA, Hidetoshi, Kyoto-shi, Kyoto 612-8501 (JP)
(74) Representative: Viering, Jentschura & Partner mbB Patent- und Rechtsanwälte
(86) International application number: PCT/JP2022/023619
(87) International publication number: WO 2022/270339

(57) **Abstract**

A wiring board according to the present disclosure includes an insulation layer, and a wiring conductor positioned on the insulation layer. The wiring conductor includes a phosphorus-containing electroless copper-plating layer positioned on the insulation layer, a nickel-containing electroless copper-plating layer positioned on the phosphorus-containing electroless copper-plating layer, and an electrolytic copper-plating layer positioned on the nickel-containing electroless copper-plating layer.

## Description

### TECHNICAL FIELD

The present invention relates to a wiring board.

### BACKGROUND OF INVENTION

In recent years, reduction in adhesion (plating adhesion) of wiring conductors has become a problem with reduction in coefficient of thermal expansion (reduction in CTE) of insulation layers included in wiring boards, miniaturization of wiring conductors, and the like. In order to solve such a problem, for example, Patent Documents 1 and 2 disclose that irregularities are provided on a surface of an insulation layer and an anchor effect generated by the irregularities is utilized to improve plating adhesion.

However, when the irregularities provided on the surface of the insulation layer are made large (roughened), forming a fine wiring conductor becomes difficult. When the irregularities are made small (smoothed), a sufficient anchor effect is not exhibited, and the adhesion between the insulation layer and the wiring conductor becomes poor.

### CITATION LIST

### PATENT LITERATURE

Patent Document 1: JP H6-196856 A
Patent Document 2: JP 2000-323815 A

### SUMMARY

### SOLUTION TO PROBLEM

A wiring board according to the present disclosure includes an insulation layer, and a wiring conductor positioned on the insulation layer. The wiring conductor includes a phosphorus-containing electroless copper-plating layer positioned on the insulation layer, a nickel-containing electroless copper-plating layer positioned on the phosphorus-containing electroless copper-plating layer, and an electrolytic copper-plating layer positioned on the nickel-containing electroless copper-plating layer.

### BRIEF DESCRIPTION OF THE DRAWINGS

FIG. 1A is a schematic view illustrating a section of a wiring board according to an embodiment of the present disclosure, and FIG. 1B is an enlarged explanatory view for explaining a region X illustrated in FIG. 1A.
FIG. 2 is an electron microscopic image of a portion corresponding to the enlarged explanatory view of FIG. 1B.

### DESCRIPTION OF EMBODIMENTS

As described above, when the irregularities provided on the surface of the insulation layer are made large (roughened), forming a fine wiring conductor becomes difficult. When the irregularities are made small (smoothed), a sufficient anchor effect is not exhibited, and the adhesion between the insulation layer and the wiring conductor becomes poor. Thus, there is a demand for a wiring board having excellent adhesion of a wiring conductor to an insulation layer and high conduction reliability.

In the wiring board of the present disclosure, as described above, the wiring conductor includes a phosphorus-containing electroless copper-plating layer, a nickel-containing electroless copper-plating layer, and an electrolytic copper-plating layer. Thus, the wiring board according to the present disclosure has excellent adhesion of the wiring conductor to the insulation layer and high conduction reliability.

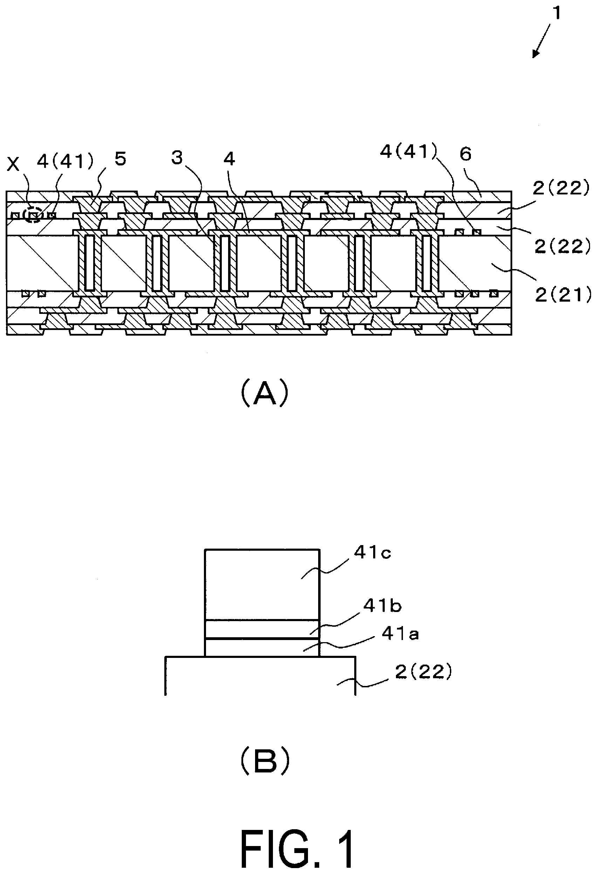

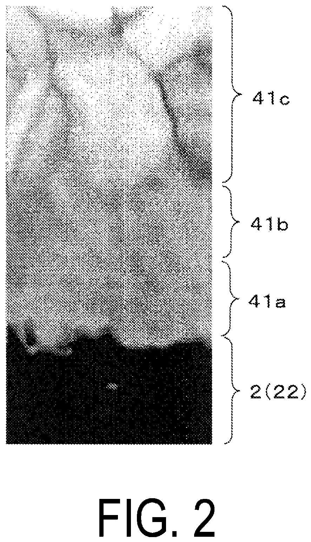

A wiring board according to the present disclosure will be described with reference to FIGs. 1 and 2. FIG. 1A is a schematic view illustrating a section of a wiring board 1 according to an embodiment of the present disclosure. The wiring board 1 according to the embodiment includes a plurality of insulation layers 2 and an electrical conductor layer 4 positioned on the insulation layers 2.

The insulation layers 2 are made of a resin such as an epoxy resin, a bismaleimidetriazine resin, a polyimide resin, a polyphenylene ether resin, or a liquid crystal polymer. These resins may be used alone or in combination of two or more. Insulation particles may be dispersed in the insulation layers 2. The insulation particles are not limited, and examples thereof may include inorganic insulation fillers made of silica, alumina, barium sulfate, talc, clay, glass, calcium carbonate, titanium oxide, and the like, for example.

In the wiring board 1 according to the embodiment, one of the plurality of insulation layers 2 is a core layer 21 and the remaining insulation layers 2 are build-up insulation layers 22. The core layer 21 has a thickness in a range from 0.04 mm to 5 mm, for example.

The core layer 21 includes a through-hole conductor 3 for electrically connecting the electrical conductor layers 4 on upper and lower surfaces of the core layer 21. The through-hole conductor 3 is located in through-holes penetrating the upper and lower surfaces of the core layer 21. The through-hole conductor 3 is formed of part of the electrical conductor layer 4, for example. The through-hole conductor 3 is connected to the electrical conductor layers 4 on both surfaces of the core layer 21.

The build-up insulation layers 22 have a thickness in a range from 2 µm to 100 µm, for example. The build-up insulation layers 22 may be made of the same resin or different resins.

The electrical conductor layer 4 is positioned on a main surface of the insulation layer 2, that is, on each of a main surface of the core layer 21 and a main surface of the build-up insulation layer 22. The electrical conductor layer 4 is made of a conductor such as copper, for example, a copper foil or copper plating. A thickness of the electrical conductor layer 4 is not particularly limited, and, for example, is in a range from 1 µm to 50 µm. When a plurality of electrical conductor layers 4 are provided, the electrical conductor layers 4 may be the same electrical conductors or different electrical conductors.

Each of the build-up insulation layers 22 includes a via-hole conductor 5 for electrically connecting the electrical conductor layers 4 positioned above and below the build-up insulation layer 22. The via-hole conductor 5 is obtained by depositing, for example, copper plating, in a via hole penetrating the upper and lower surfaces of the build-up insulation layer 22. The via hole penetrating the upper and lower surfaces of the build-up insulation layer 22 is formed by, for example, laser processing such as processing using CO₂ laser, UV-YAG laser, excimer laser, or the like.

Part of the electrical conductor layer 4 functions as a wiring conductor 41. As illustrated in FIG. 1B, when the wiring conductor 41 is viewed in a section in a width direction, the wiring conductor 41 includes a phosphorus-containing electroless copper-plating layer 41a, a nickel-containing electroless copper-plating layer 41b positioned on the phosphorus-containing electroless copper-plating layer 41a, and an electrolytic copper-plating layer 41c positioned on the nickel-containing electroless copper-plating layer 41b. FIG. 1B is an enlarged explanatory view for explaining a region X illustrated in FIG. 1A.

The phosphorus-containing electroless copper-plating layer 41a is a portion serving as a base of the wiring conductor 41 and is in contact with the insulation layer 2. Since the phosphorus-containing electroless copper-plating layer 41a contains phosphorus, copper is efficiently deposited on the fine irregularities present on the surface of the insulation layer 2. That is, the phosphorus-containing electroless copper-plating layer 41a is deposited in such a manner as to fill recessed portions of the surface of the insulation layer 2 and cover protruding portions thereof. As a result, the phosphorus-containing electroless copper-plating layer 41a firmly adheres to the surface of the insulation layer 2. The phosphorus-containing electroless copper-plating layer 41a has a thickness in a range from 50 nm to 1000 nm, for example.

The proportion of phosphorus contained in the phosphorus-containing electroless copper-plating layer 41a is not limited. For example, phosphorus is contained at a proportion in a range from 0.1 at% to 1 at%, and is preferably contained at a proportion of 0.5 at%, as a lower limit value, or more. When phosphorus is contained at such a proportion, for example, the phosphorus-containing electroless copper-plating layer 41a having sufficient adhesion strength can be obtained without being affected by a change in plating characteristics due to contained phosphorus. The phosphorus content can be measured by, for example, energy dispersive X-ray analysis (EDX) with transmission electron microscope (TEM) analysis.

The nickel-containing electroless copper-plating layer 41b is positioned on the phosphorus-containing electroless copper-plating layer 41a. The nickel-containing electroless copper-plating layer 41b has tensile stress. Thus, the internal (expansion and contraction) stress of the wiring board 1 can be relaxed, and for example, generation of cracks in the insulation layer 2 and the wiring conductor 41 can be reduced. As a result, the conduction reliability of the wiring board 1 can be improved. The nickel-containing electroless copper-plating layer 41b has a thickness in a range from 50 nm to 1000 nm, for example.

The proportion of nickel contained in the nickel-containing electroless copper-plating layer 41b is not limited. For example, nickel is contained at a proportion in a range from 0.1 at% to 5 at%, and is preferably contained at a proportion in a range from 0.5 at% to 0.8 at%. When nickel is contained at such a proportion, brittleness of plating characteristics due to contained nickel can be reduced, and an excellent stress relaxation effect can be exhibited, which can further reduce generation of cracks. The nickel content can be measured by EDX with TEM analysis in the same manner as that in the case of the phosphorus content.

In the nickel-containing electroless copper-plating layer 41b, nickel may be uniformly distributed or may be ununiformly distributed. For example, in a thickness direction of the nickel-containing electroless copper-plating layer 41b, the nickel content in both surface layer portions may be smaller than the nickel content in a central portion. Peeling due to thermal stress or the like is likely to occur at the boundary with the insulation layer 2 and at the boundary with the electrolytic copper-plating layer 41c described later. Thus, reducing the content of nickel, which has tensile stress, in the vicinity of the boundary (that is, both surface layer portions of the nickel-containing electroless copper-plating layer 41b) can further reduce the occurrence of peeling, cracking, and the like. In the present specification, the "surface layer portions" mean regions from both surfaces of the nickel-containing electroless copper-plating layer 41b to a depth of 10%, and the "central portion" means a region other than the "both surface layer portions".

At least part of the phosphorus-containing electroless copper-plating layer 41a and the nickel-containing electroless copper-plating layer 41b may have an amorphous structure. FIG. 2 is an electron microscopic image of a portion corresponding to the enlarged explanatory view of FIG. 1B. In FIG. 2, both the phosphorus-containing electroless copper-plating layer 41a and the nickel-containing electroless copper-plating layer 41b have an amorphous structure. That is, as illustrated in FIG. 2, the electrolytic copper-plating layer 41c described later has a crystalline structure, but the phosphorus-containing electroless copper-plating layer 41a and the nickel-containing electroless copper-plating layer 41b do not have such a crystalline structure. The amorphousness does not have a boundary surface in a specific direction. Thus, at least part of the phosphorus-containing electroless copper-plating layer 41a and the nickel-containing electroless copper-plating layer 41b having an amorphous structure can relax stresses from various directions. As a result, occurrence of peeling, cracking, and the like can be further reduced.

The electrolytic copper-plating layer 41c is a layer serving as a body of the wiring conductor 41, and is positioned on the nickel-containing electroless copper-plating layer 41b. In the wiring conductor 41, charges flow mainly in the electrolytic copper-plating layer 41c. The electrolytic copper-plating layer 41c has a thickness in a range from 1 µm to 100 µm, for example.

Solder resists 6 are positioned on part of both surfaces of the wiring board 1 according to the embodiment. The solder resist 6 is made of, for example, an acrylic-modified epoxy resin. The solder resist 6 has a function of protecting the electrical conductor layer 4 and the like from solder when, for example, an electronic component is mounted or connection to a motherboard or the like is performed.

A method of forming the wiring board 1 according to the embodiment is not limited, and the wiring board 1 is formed by, for example, the following method.

First, a double-sided copper-clad laminate plate to be the core layer 21 is prepared, and a through-hole is formed therein. The through-hole is formed by, for example, drill processing, laser processing, blast processing, or the like. After the through-hole is formed, a desmear treatment is performed to remove residues. Copper is then removed by etching.

The surface of the core layer 21 from which copper has been removed and the inner wall surface of the through-hole are subjected to an electroless copper plating treatment. When the electroless copper plating treatment is performed, a reducing agent is used to deposit a metal (copper). When a large amount of phosphorus, boron, or the like, which is a reducing agent component, is co-deposited in the plating film in the metal deposition process, amorphous plating is likely to be formed. Thus, in order to form the amorphous plating, a reducing agent containing, for example, phosphorus or boron is preferably used as the reducing agent. Containing phosphorus in a plating bath at a proportion in a range from 7 wt% to 11 wt% in a case of using a reducing agent containing phosphorus facilitates formation of amorphous plating.

Using, for example, hypophosphorous acid as the reducing agent containing phosphorus causes phosphorus to remain in the electroless copper-plating, and the phosphorus-containing electroless copper-plating layer 41a is formed on the insulation layer 2. The phosphorus-containing electroless copper-plating layer 41a not only firmly adheres to the surface of the insulation layer 2 as described above, but also protects the surface of the insulation layer 2 from a strong alkaline substance used when the nickel-containing electroless copper-plating layer 41b is formed. As a result, damage to the insulation layer 2 can be prevented, and adhesion between the resin and the plating can be ensured.

Next, nickel-containing electroless copper plating treatment is performed on the surface of the phosphorus-containing electroless copper-plating layer 41a formed on the surface of the core layer 21 and the inner wall of the through-hole. When the nickel-containing electroless copper plating treatment is performed, formalin is used as a reducing agent, for example. The nickel-containing electroless copper-plating layer 41b is thus formed on the surface of the phosphorus-containing electroless copper-plating layer 41a. A nickel-containing electroless copper plating solution used for the nickel-containing electroless copper plating treatment contains additives such as nickel and a surfactant in addition to copper. In the process of forming the phosphorus-containing electroless copper-plating layer 41a, additives such as nickel and surfactants are randomly present. As a result, in the phosphorus-containing electroless copper-plating layer 41a, the crystals are inhibited from being uniformly arranged, and amorphous plating is likely to be formed.

Next, a photosensitive plating resist (for example, a dry film resist) is formed on the surface of the nickel-containing electroless copper-plating layer 41b, and an opening where electrolytic copper plating is deposited (a portion where the electrolytic copper-plating layer 41c is to be formed) is formed by exposure and development. Then, copper is deposited by electrolytic copper plating on the surface of the nickel-containing electroless copper-plating layer 41b formed in the opening of the plating resist and on the inner wall surface of the through-hole. The deposited copper finally becomes the electrolytic copper-plating layer 41c. After the deposition, the plating resist is removed with an alkaline solution or the like.

Next, the remaining portions of the phosphorus-containing electroless copper-plating layer 41a and the nickel-containing electroless copper-plating layer 41b where the electrolytic copper-plating layer 41c is not formed are removed by, for example, etching. After the electrical conductor layer 4 is formed in this manner, heat treatment is performed, for example, at a temperature in a range from 120°C to 200°C for a length of time of about from 0.5 hour to 2 hours. This makes it possible to obtain a distribution in which the nickel content in both surface layer portions is smaller than the nickel content in the central portion.

The wiring conductor 41 including the phosphorus-containing electroless copper-plating layer 41a, the nickel-containing electroless copper-plating layer 41b, and the electrolytic copper-plating layer 41c is formed on the surface of the core layer 21 (insulation layer 2) through such a procedure. A through-hole conductor 3 is formed in the through-hole formed in the core layer 21. In the through-hole conductor 3 as well, the phosphorus-containing electroless copper-plating layer 41a, the nickel-containing electroless copper-plating layer 41b, and the electrolytic copper-plating layer 41c are positioned in this order from the wall surface of the through-hole, as in the wiring conductor 41. The electrical conductor layer 4 other than the wiring conductor 41 may be formed through the same procedure as that in the case of the wiring conductor 41, or copper of the double-sided copper-clad laminate plate may be used without being removed.

Next, the build-up insulation layer 22 is formed on the surfaces of the core layer 21, the electrical conductor layer 4, and the wiring conductor 41, and the above-described steps are repeated to form the wiring conductor 41 on the surface of the build-up insulation layer 22. A via-hole conductor 5 is formed in the via hole formed in the build-up insulation layer 22. In the core layer 21, the through-hole corresponds to a penetrating hole, and in the build-up insulation layer 22, the via hole corresponds to a penetrating hole.

The wiring conductor 41 and the via-hole conductor 5 include the phosphorus-containing electroless copper-plating layer 41a, the nickel-containing electroless copper-plating layer 41b, and the electrolytic copper-plating layer 41c. In the build-up insulation layer 22 as well, the electrical conductor layer 4 other than the wiring conductor 41 may be formed through the same procedure as that in the case of the wiring conductor 41, or copper of the double-sided copper-clad laminate plate may be used without being removed.

Repeating the above-described steps for the build-up insulation layer 22 results in formation of a desired number of build-up layers.

Next, the solder resist 6 provided with an opening at a desired position is formed on the surface of the build-up layer. As described above, the solder resist 6 is made of, for example, an acrylic-modified epoxy resin. The electrical conductor layer 4 exposed through the opening functions as a pad. The wiring board 1 according to the embodiment obtained as described above has excellent adhesion of the wiring conductor to the insulation layer and excellent conduction reliability. The wiring board in the present specification has excellent adhesion of the wiring conductor to the insulation layer and excellent conduction reliability even when the surface of the insulation layer has a surface roughness as low as an arithmetic mean roughness Ra in a range from 0.1 µm to 0.8 µm, for example.

The wiring board of the present disclosure is not limited to the embodiment described above. For example, in the wiring board 1 according to the embodiment, as illustrated in FIG. 1, both the phosphorus-containing electroless copper-plating layer 41a and the nickel-containing electroless copper-plating layer 41b have an amorphous structure. However, in the wiring board of the present disclosure, at least part of the phosphorus-containing electroless copper-plating layer and the nickel-containing electroless copper-plating layer may have an amorphous structure.

As illustrated in FIG. 1A, in the wiring board 1 according to the embodiment, the through-hole conductor 3 is positioned only on the inner wall surface of the through-hole. However, in the wiring board of the present disclosure, the through-hole conductor may fill the through-hole. Furthermore, as illustrated in FIG. 1A, in the wiring board 1 according to the embodiment, the via conductor 5 fills the via hole. However, in the wiring board of the present disclosure, the via conductor may be positioned only on the inner wall surface of the via hole.

### REFERENCE SIGNS

1 Wiring board
2 Insulation layer
21 Core layer
22 Build-up insulation layer
3 Through-hole conductor
4 Electrical conductor layer
41 Wiring conductor
41a Phosphorus-containing electroless copper-plating layer
41b Nickel-containing electroless copper-plating layer
41c Electrolytic copper-plating layer
5 Via-hole conductor
6 Solder resist

## Claims

1. A wiring board comprising:
an insulation layer; and
a wiring conductor positioned on the insulation layer,
wherein the wiring conductor comprises
a phosphorus-containing electroless copper-plating layer positioned on the insulation layer;
a nickel-containing electroless copper-plating layer positioned on the phosphorus-containing electroless copper-plating layer; and
an electrolytic copper-plating layer positioned on the nickel-containing electroless copper-plating layer.

2. The wiring board according to claim 1, wherein at least part of the phosphorus-containing electroless copper-plating layer and the nickel-containing electroless copper-plating layer comprises a non crystalline structure.

3. The wiring board according to claim 1 or 2, wherein the phosphorus-containing electroless copper-plating layer contains phosphorus at a proportion in a range from 0.5 at% to 1 at%.

4. The wiring board according to any one of claims 1 to 3, wherein the nickel-containing electroless copper-plating layer contains nickel at a proportion in a range from 0.5 at% to 0.8 at%.

5. The wiring board according to any one of claims 1 to 4, wherein in the nickel-containing electroless copper-plating layer, a nickel content in both surface layer portions is smaller than a nickel content in a central portion in a thickness direction of the nickel-containing electroless copper-plating layer.

6. The wiring board according to any one of claims 1 to 5, wherein the insulation layer is further provided with a penetrating hole, and the wiring conductor is provided in the penetrating hole.
